# FASCICULE DE BREVET EUROPEEN

(11) **EP 3 937 320 B1**
(45) Date de publication et mention de la délivrance du brevet: **20.05.2026**
(21) Numéro de dépôt: 21177834.5
(22) Date de dépôt: 04.06.2021
(51) Int. Cl.: H02B 11/10, H02B 11/12

(54) **DISPOSITIF ÉLECTRIQUE COMPRENANT UN DISJONCTEUR ET UNE PRISE**
ELEKTRISCHE VORRICHTUNG, DIE EINEN SCHUTZSCHALTER UND EINE STECKDOSE UMFASST
ELECTRICAL DEVICE COMPRISING A CIRCUIT BREAKER AND A SOCKET

(30) Priorité: 07.07.2020 FR 2007179
(43) Date de publication de la demande: 12.01.2022
(73) Titulaire: Schneider Electric Industries SAS, 92500 Rueil-Malmaison (FR)
(72) Inventeur: MELEY, Jean-Pierre, 38330 Saint Ismier (FR); TOTI BUTTIN, Frédéric, 38800 Le Pont de Claix (FR)
(74) Mandataire: Plasseraud IP

(56) Documents cités:
- DE-U1- 29 513 997
- US-A- 5 206 468
- ABB: "Medium voltage products: VD4 withdrawable vacuum circuit breaker", 7 November 2015 (2015-11-07), XP055786812, Retrieved from the Internet <URL:http://adakbn-co.com/wp-content/uploads/2015/11/VD4-CB.pdf> [retrieved on 20210317]

## Description

### Domaine technique

La présente divulgation est relative à un dispositif électrique comprenant un disjoncteur et une prise connectée au disjoncteur. La présente divulgation vise également une installation électrique.

### Technique antérieure

De manière connue, une cellule d'appareillage électrique haute tension ou moyenne tension comprend une structure métallique au sein de laquelle plusieurs compartiments distincts sont logés. Par exemple, la cellule d'appareillage comprend un compartiment dit « jeu de barres », un compartiment dit « appareillage », un compartiment dit « câbles » et un compartiment dit « caisson basse tension », entre autres.

Les compartiments jeu de barres et câbles regroupent des barres métalliques conductrices amont et aval d'un réseau électrique haute tension. Les compartiments jeu de barres et câbles sont situés par exemple à l'arrière de la cellule d'appareillage.

Le compartiment appareillage est muni d'un appareil interrupteur. Par exemple, l'appareil interrupteur est un disjoncteur. L'appareil interrupteur comprend un mécanisme de manœuvre permettant à l'appareil interrupteur de passer d'une position ouverte à une position fermée. Dans la position fermée, un passage d'un courant électrique dans l'appareil interrupteur est autorisé. Dans la position ouverte, le passage du courant électrique dans l'appareil interrupteur est empêché.

Le caisson basse tension comporte des composants électriques basse tension permettant de protéger et contrôler l'appareil interrupteur du compartiment appareillage. Le caisson basse tension comprend en particulier des circuits électriques de contrôle-commande impliqués dans le contrôle et la commande de l'appareil interrupteur. Les circuits électriques de contrôle-commande commandent notamment le passage entre les positions ouverte et fermée de l'appareil interrupteur selon les conditions du réseau. Les circuits électriques de contrôle-commande comportent par exemple des câbles et un ou plusieurs relais de protection et commande.

Généralement, l'appareil interrupteur est monté dans le compartiment appareillage sur un chariot mobile déplaçable à l'intérieur du compartiment appareillage. Une fois à l'intérieur, le déplacement du chariot mobile permet également de déplacer l'appareil interrupteur entre une position embrochée et une position débrochée. Dans la position embrochée, l'appareil interrupteur est connecté au jeu de barres. Dans la position débrochée, l'appareil interrupteur est déconnecté du jeu de barres. Le chariot mobile permet également, au-delà de la position débrochée, d'extraire l'appareil interrupteur à l'extérieur du compartiment appareillage de la cellule.

Classiquement, un cordon muni d'une prise dite « prise basse tension » permet de réaliser une connexion entre les circuits électriques contrôle-commande du caisson basse tension et l'appareil interrupteur.

La prise basse tension permet notamment de faire remonter une information relative à la position ouverte ou fermée de l'appareil interrupteur vers les circuits électriques de contrôle-commande du caisson basse tension. Lorsque l'appareil interrupteur passe de la position embrochée à la position débrochée, les circuits électriques commandent le passage de l'appareil interrupteur de la position fermée à la position ouverte. En outre, en cas d'extraction de l'appareil interrupteur de la cellule, un déchargement du mécanisme de manœuvre de l'appareil interrupteur a lieu, ce qui assure la sécurité des opérateurs de maintenance.

La prise basse tension comporte une partie fixe et une partie mobile. La partie mobile est configurée pour être connectée de manière amovible à la partie fixe. Lorsque la partie mobile est connectée à la partie fixe, la prise est connectée et verrouillée sur l'appareil interrupteur. Lorsque la prise n'est pas connectée et verrouillée sur l'appareil interrupteur, un mécanisme de verrouillage mécanique évite que le chariot mobile se déplace, de manière à éviter que l'appareil interrupteur se déplace entre les positions embrochée et débrochée. Par exemple, le mécanisme de verrouillage mécanique peut comprendre un crochet, un ressort et un cliquet coopérant entre eux.

Quand la partie fixe et la partie mobile de la prise sont déconnectées, le ressort est détendu, ce qui provoque un déplacement du cliquet vers une position empêchant le déplacement du chariot. L'appareil interrupteur est ainsi empêché de se déplacer entre les positions embrochée et débrochée.

Quand la partie fixe et la partie mobile de la prise sont connectées, le crochet est positionné de manière à comprimer le ressort et le cliquet se déplace vers une position permettant le déplacement du chariot. L'appareil interrupteur est ainsi autorisé à se déplacer entre les positions embrochée et débrochée.

Ainsi, le chariot peut uniquement être déplacé entre la position embrochée et la position débrochée lorsque la prise est connectée et verrouillée. Les risques d'électrisation, voire d'électrocution, sont ainsi limités pour un opérateur manipulant l'appareil interrupteur.

Cependant, l'emploi du mécanisme de verrouillage mécanique présente un risque de défaillance important dû à l'usure des pièces. En particulier, l'usure peut conduire à ce que le déplacement de l'appareil interrupteur soit autorisé même lorsque la prise n'est pas connectée et verrouillée, mettant ainsi en danger la vie de l'opérateur. De plus, l'arrangement des pièces du mécanisme de verrouillage mécanique peut s'avérer complexe.

Le document Abb : "Medium voltage products: VD4 withdrawable vacuum circuit breaker", 7 novembre 2015, XP055786812, http://adakbn-co.com/wp-content/uploads/2015/11/VD4-CB.pdf, divulgue un dispositif électrique à disjoncteur, dans lequel une prise est pourvue d'un moyen de verrouillage.

DE 295 13 997 U1 divulgue une prise munie d'un moyen de verrouillage, avec un capteur qui repère la position du moyen de verrouillage.

US 5,206,468 divulgue un verrouillage mécanique reliant le levier d'une prise Harding.

### Résumé

La présente divulgation vise à améliorer la situation.

À cette fin, il est décrit un dispositif électrique selon la revendication 1.

Ainsi, avantageusement, la position verrouillée et/ou la position déverrouillée du moyen de verrouillage est détectée par le capteur. Ainsi, le déplacement du disjoncteur entre la position débrochée et la position embrochée est autorisé ou empêché par le capteur. Le risque de défaillance dû à l'usure des pièces mécaniques est ainsi réduit.

De surcroît, le rechargement du mécanisme de manœuvre du disjoncteur est uniquement autorisé lorsque la prise est connectée au disjoncteur et le capteur détecte la position verrouillée du moyen de verrouillage. Le non-respect de cette double condition interdit le déplacement du disjoncteur de la position débrochée à la position embrochée du disjoncteur. Ainsi, on assure que le disjoncteur est relié et verrouillé aux circuits électriques de contrôle-commande avant de le déplacer en position embroché.

Accessoirement, l'emploi du capteur permet d'éviter l'installation de mécanismes de verrouillage mécaniques complexes.

Selon une première caractéristique de l'invention, le capteur est en outre configuré pour provoquer un désarmement du disjoncteur avant le déplacement du disjoncteur depuis l'intérieur vers l'extérieur de la cellule d'appareillage électrique lorsque le moyen de verrouillage est dans la position déverrouillée et/ou pour provoquer un réarmement du disjoncteur et autoriser le déplacement dudit disjoncteur entre la position embrochée et la position débrochée lorsque le moyen de verrouillage est dans la position verrouillée.

Selon une seconde caractéristique de l'invention, le capteur est monté sur un support, le support ayant une surface interposée entre le capteur et le levier.

Selon des modes de réalisations préférés, le dispositif électrique comprend une ou plusieurs des caractéristiques suivantes, prises seules ou en combinaison :
- le capteur est en outre configuré pour communiquer à un système numérique de contrôle-commande la détection de la position verrouillée et/ou de la position déverrouillée du moyen de verrouillage, le système numérique de contrôle-commande étant configuré pour commander le désarmement du disjoncteur et/ou le réarmement du disjoncteur ;
- le moyen de verrouillage comprend un levier faisant face au capteur lorsque le moyen de verrouillage est dans la position verrouillée ;
- le capteur est un capteur de position apte à détecter le levier lorsque le moyen de verrouillage est dans la position verrouillée ;
- le capteur est un capteur inductif ;
- le capteur est connecté en série dans la prise ; et
- le capteur est prévu à l'intérieur du boîtier.

Selon un autre aspect, il est décrit une installation électrique comprenant une cellule d'appareillage électrique et un dispositif électrique tel que décrit ci-avant, dans laquelle la prise est en outre configurée pour être connectée à un compartiment basse tension de la cellule d'appareillage électrique, la prise étant installée entre le disjoncteur et le compartiment basse tension, le compartiment basse tension logeant des composants électriques basse tension.

Selon des modes de réalisations préférés, l'installation électrique comprend une ou plusieurs des caractéristiques suivantes, prises seules ou en combinaison :
- le boîtier comporte une partie fixe et une partie mobile, la partie fixe étant destinée à être installée sur le disjoncteur ou sur le compartiment basse tension, la partie mobile étant connectée de manière amovible sur la partie fixe, la partie mobile étant maintenue en position par rapport à la partie fixe lorsque le moyen de verrouillage est dans la position verrouillée ;
- l'au moins un élément d'ancrage est prévu sur la partie fixe du boîtier, le moyen de verrouillage étant relié à la partie mobile ;
- le capteur est logé dans la partie mobile du boîtier ; et
- la cellule d'appareillage électrique est une cellule moyenne tension ou haute tension.

### Brève description des dessins

D'autres caractéristiques et avantages apparaîtront au cours de la description suivante d'une de ses formes de réalisation, donnée à titre d'exemple non limitatif, en regard des dessins joints. Sur les dessins :
[Fig. 1] montre une coupe longitudinale schématique d'une installation électrique selon la présente invention.
[Fig. 2] montre une vue schématique en perspective d'un appareil électrique selon la présente invention.
[Fig. 3] montre une vue schématique en perspective d'une prise de l'appareil électrique de la figure 2 dans une première position.
[Fig. 4] montre une coupe longitudinale schématique vue en perspective de la prise de la figure 3.
[Fig. 5] montre une vue schématique en perspective de la prise de la figure 3 dans une deuxième position.
[Fig. 6] montre une vue schématique en perspective d'un montage selon la présente invention placé à l'intérieur de la prise de la figure 3.

### Description des modes de réalisation

Sur les différentes figures, les mêmes références désignent des éléments identiques ou similaires.

Dans la description qui suit, les indications de positionnement dans l'espace telles que haut, bas, supérieur, inférieur, horizontal, vertical etc. sont données pour la clarté de l'exposé mais ne sont bien entendu pas limitatives.

Dans la description qui suit, on utilise les termes « basse tension », « moyenne tension », « haute tension », qui sont bien connus de l'homme du métier. A titre d'exemple, on peut considérer que par l'expression « basse tension » on entend toute tension inférieure ou égale à 1 kV. Par les expressions « moyenne tension » ou « haute tension » on entend toute tension supérieure à 1 kV. Alternativement, l'expression « moyenne tension » peut comprendre toute tension supérieure à 1 kV et inférieure ou égale à 52 kV, et l'expression « haute tension » peut comprendre toute tension supérieure à 52 kV.

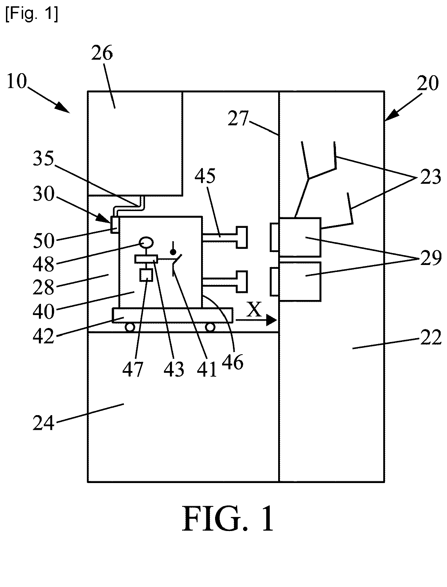

La figure 1 montre une coupe longitudinale schématique d'une installation électrique 10. L'installation électrique 10 comprend une cellule d'appareillage électrique 20 et un dispositif électrique 30. De préférence, la cellule d'appareillage électrique 20 est une cellule moyenne tension ou haute tension.

La cellule d'appareillage électrique 20 comprend plusieurs compartiments distincts. En particulier, la cellule d'appareillage électrique 20 comprend un compartiment, dit compartiment jeu de barres 22, un compartiment, dit compartiment câbles 24, un compartiment dit compartiment basse tension 26, et un compartiment, dit compartiment appareillage 28.

Le compartiment jeu de barres 22 comprend un ensemble de barres métalliques 23. Les barres métalliques 23 conduisent un courant électrique au sein de la cellule d'appareillage électrique 20. De préférence, le compartiment jeu de barres 22 est situé à l'arrière de la cellule d'appareillage 20.

Le compartiment câbles 24 est destiné au raccordement des câbles (non illustrés) de la cellule d'appareillage 20. En outre, le compartiment câbles 24 comprend des capteurs (non illustrés) de mesure d'un courant ou d'une tension dans la cellule d'appareillage 20. Par exemple, le compartiment câbles 24 est situé à l'avant et dans une partie inférieure de la cellule d'appareillage 20.

Le compartiment basse tension 26 comprend un ensemble de composants électriques basse tension (non illustrés). En particulier, le compartiment basse tension 26 comprend un ou plusieurs relais de protection et de commande de l'appareil électrique 30. De préférence, le compartiment basse tension 26 est situé à l'avant et dans une partie supérieure de la cellule d'appareillage 20.

Le compartiment appareillage 28 est avantageusement situé à l'avant de la cellule d'appareillage 20, à mi-hauteur entre le compartiment câbles 24 et le compartiment basse tension 26. Une paroi 27 sépare le compartiment appareillage 28 du compartiment jeu de barres 22. La paroi 27 est munie d'un jeu de traversées isolantes 29. Le jeu de traversées isolantes 29 comporte des connecteurs fixes reliés aux barres métalliques 23. Le compartiment appareillage 28 comprend en outre une porte (non illustrée) séparant un intérieur et un extérieur du compartiment appareillage 28.

Le compartiment appareillage 28 loge l'appareil électrique 30 et un chariot 42. L'appareil électrique 30 comprend un disjoncteur 40 et une prise 50.

Le chariot 42 est monté mobile en translation selon une direction longitudinale X. Ainsi, le chariot 42 peut se déplacer à l'intérieur du compartiment appareillage 28, dans lequel le disjoncteur 40 peut se déplacer entre une position embrochée et une position débrochée qui seront expliquées ultérieurement. Le chariot 42 peut aussi se déplacer entre l'intérieur et l'extérieur du compartiment appareillage 28. Avantageusement, des moyens d'entraînement motorisés du chariot 42 sont prévus dans le compartiment appareillage 28. Les moyens d'entraînement motorisés comprennent un moteur d'entraînement (non illustré). Les moyens d'entraînement motorisés du chariot 42 commandent la translation selon la direction longitudinale X du chariot 42.

Le disjoncteur 40 est relié au compartiment basse tension 26 par l'intermédiaire de la prise 50, comme cela sera détaillé ultérieurement.

Le disjoncteur 40 comporte une face avant 44 et une face arrière 46. Au moins une broche de connexion 45 est prévue sur la face arrière 46. Avantageusement, chaque broche de connexion 45 est positionnée de manière à faire face à un connecteur fixe du jeu de traversées isolantes 29 lorsque le disjoncteur 40 est introduit dans le compartiment appareillage 28.

Le disjoncteur 40 est en outre muni d'un ensemble de contacts 41. Les contacts 41 sont configurés pour se déplacer entre une position ouverte et une position fermée.

Un mécanisme de manœuvre à ressorts 43 est en outre prévu dans le disjoncteur 40. Le mécanisme de manœuvre à ressorts 43 comprend un ensemble de ressorts de manœuvre. De préférence, le mécanisme de manœuvre à ressorts 43 comprend un ressort d'ouverture et un ressort de fermeture.

Avantageusement, le mécanisme de manœuvre à ressorts 43 comporte également un moteur de réarmement 48. Le moteur de réarmement 48 permet de charger en énergie potentielle les ressorts de manœuvre. Ainsi, le disjoncteur 40 peut passer d'une position désarmée à une position réarmée. Dans la position désarmée, les ressorts de manœuvre sont dépourvus d'énergie potentielle. Dans la position réarmée, les ressorts de manœuvre sont chargés en énergie potentielle élastique.

Le disjoncteur 40 comprend en outre au moins une bobine 47 de déclenchement des ressorts de manœuvre. Par exemple, le disjoncteur 40 peut comporter une première bobine 47 de déclenchement du ressort d'ouverture et une deuxième bobine 47 de déclenchement du ressort de fermeture. Le déclenchement des ressorts de manœuvre entraine la libération de l'énergie potentielle emmagasinée dans lesdits ressorts de manœuvre.

L'action conjointe du mécanisme de manœuvre à ressorts 43 et de la bobine 47 permettent le passage des contacts 41 du disjoncteur 40 entre la position ouverte et la position fermée.

En particulier, le déclenchement par la bobine 47 du ressort d'ouverture provoque l'ouverture des contacts 41. De manière analogue, le déclenchement par la bobine 47 du ressort de fermeture provoque la fermeture des contacts 41.

Après déclenchement, le moteur de réarmement 48 permet de recharger les ressorts de manœuvre. Ainsi, lorsque le disjoncteur 40 est dans la position réarmée et les contacts 41 sont dans la position fermée, le disjoncteur 40 est capable de réaliser une séquence rapide d'ouverture des contacts 41, puis de fermeture-ouverture des contacts 41 si nécessaire (cycle O-F-O).

Le disjoncteur 40 est monté sur le chariot 42. Ainsi, le disjoncteur 40 peut être déplacé selon la direction longitudinale X à l'intérieur du compartiment appareillage 28 entre une position embrochée et une position débrochée. Le disjoncteur 40 est donc un disjoncteur débrochable.

Le disjoncteur 40 est de préférence un disjoncteur moyenne tension ou haute tension.

Le disjoncteur 40 permet de couper et de rétablir une circulation du courant électrique au sein de la cellule d'appareillage 20. En particulier, dans la position ouverte des contacts 41, le passage du courant électrique dans le disjoncteur 40 est interrompu. Dans la position fermée des contacts 41, le passage du courant électrique dans le disjoncteur 40 est possible.

Dans la position débrochée, illustrée à la figure 1, chaque broche de connexion 45 est déconnectée des connecteurs fixes du jeu de traversées isolantes 29. Ainsi, le disjoncteur 40 est déconnecté des barres métalliques 23. Le courant électrique est donc empêché de circuler dans le disjoncteur 40.

Dans la position embrochée, chaque broche de connexion 45 est connectée aux connecteurs fixes du jeu de traversées isolantes 29. Ainsi, le disjoncteur 40 est relié aux barres métalliques 23 et n'interdit pas au courant de circuler dans le disjoncteur 40, à condition que les contacts 41 du disjoncteur soient dans la position fermée.

Le passage entre la position débrochée et la position embrochée est possible grâce à la translation selon la direction transversale X du chariot 42.

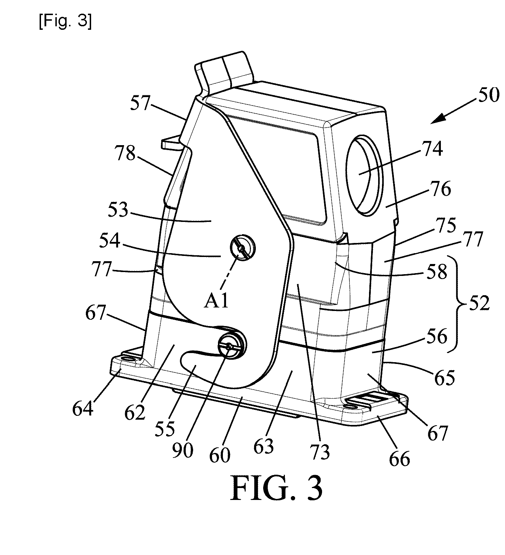

Maintenant sera décrite la prise 50 en référence aux figures 3 à 5.

La prise 50 comprend un boîtier 52 et un moyen de verrouillage 54.

Le boîtier 52 comprend une partie fixe 56 et une partie mobile 58. Avantageusement, la partie fixe 56 et la partie mobile 58 sont creuses. Par exemple, la partie fixe 56 et la partie mobile 58 du boîtier 52 sont faites en matériau métallique. Alternativement, la partie mobile 58 est faite en matériau métallique et la partie fixe 56 est faite en matériau polymère.

La partie fixe 56 comprend une base 60 et un corps 62. La base 60 et le corps 62 sont reliés entre eux. De préférence, la base 60 est réalisée d'un seul tenant avec le corps 62.

Le corps 62 a de préférence une forme sensiblement prismatique comprenant une face avant 63, une face arrière 65, et deux faces latérales 67. La face avant 63 est sensiblement parallèle à la face arrière 65. De même, les deux faces latérales 67 sont sensiblement parallèles entre elles. Par exemple, la face avant 63 et la face arrière 65 sont sensiblement perpendiculaires aux faces latérales 67. La face avant 62, la face arrière 65 et les faces latérales 67 forment un contour du corps 62.

La base 60 comprend une première aile 64 et une deuxième aile 66. Les première et deuxième ailes 64, 66 s'étendent sensiblement perpendiculairement au corps 62. De préférence, les première et deuxième ailes 64, 66 s'étendent depuis les faces latérales 67 du corps 62.

La partie fixe 56 est destinée à être reliée au compartiment basse tension 26 de la cellule d'appareillage électrique 20 ou au disjoncteur 40. En particulier, les premier et deuxième ailes 64, 66 sont vissées au compartiment basse tension 26 ou au disjoncteur 40.

La partie mobile 58 comprend un premier trou 74 et un deuxième trou (non visible). Le premier trou 74 est arrangé sur une première face 76 de la partie mobile 58. Le deuxième trou est avantageusement arrangé sur une deuxième face 78 de la partie mobile 58.

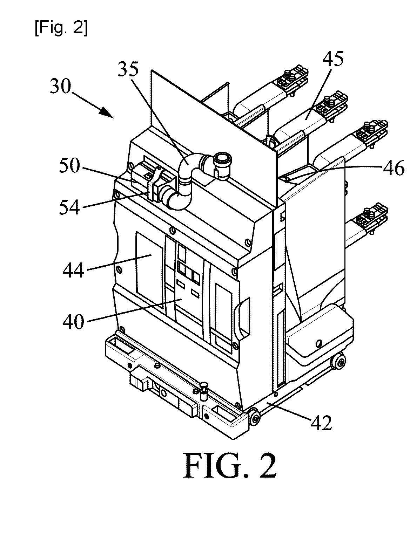

Le premier trou 74 est conformé pour recevoir un cordon 35 de sortie d'un ensemble de câbles (non illustrés) traversant la prise 50. Le cordon 35 est notamment visible sur les figures 1 et 2. Lorsque la partie fixe 56 est reliée au compartiment basse tension 26, le cordon 35 relie la prise 50 au disjoncteur 40. Au contraire, lorsque la partie fixe 56 est reliée au disjoncteur 40, le cordon 35 relie la prise 50 au compartiment basse tension 26.

La partie mobile 58 est destinée à être connectée de manière amovible sur la partie fixe 56. Lorsque la partie mobile 58 est connectée sur la partie fixe 56, la prise 50 est connectée au disjoncteur 40 et au compartiment basse tension 26. Avantageusement, au moins une portion de la partie mobile 58 destinée à entrer en contact avec la partie fixe 56 est sensiblement prismatique avec une face avant 73, une face arrière 75 et deux faces latérales 77. Un contour formé par la face avant 73, la face arrière 75 et les faces latérales 77 a une forme et une dimension sensiblement égales à une forme et une dimension du contour du corps 62.

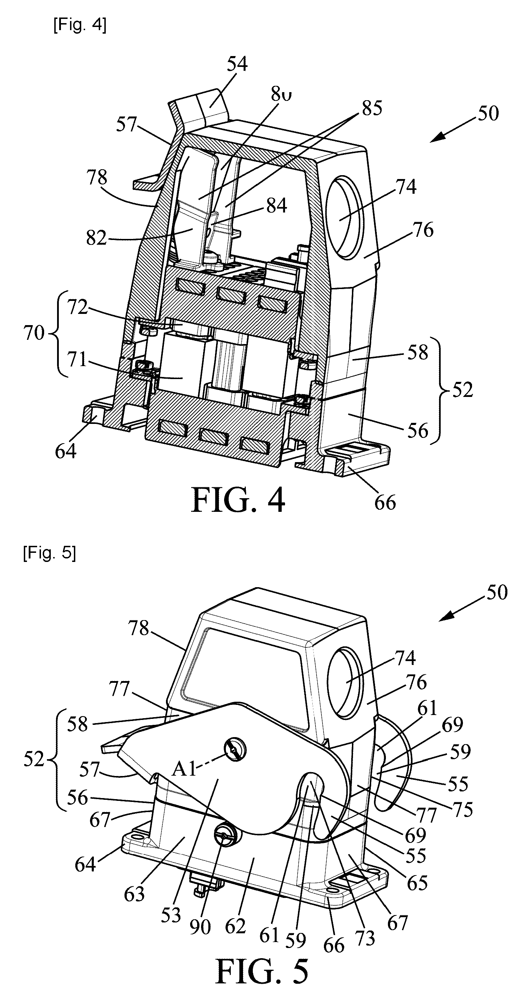

Comme visible en particulier sur la figure 4, un bornier modulaire 70, un capteur 80 et un support 82 sont prévus à l'intérieur du boîtier 52.

Le bornier modulaire 70 comprend une première partie 71 et une deuxième partie 72. La première partie 71 est prévue dans la partie fixe 56 du boîtier 52. Avantageusement, la première partie 71 est vissée à l'intérieur de la partie fixe 56.

La deuxième partie 72 est prévue dans la partie mobile 58 du boîtier 52. Avantageusement, la deuxième partie 72 est vissée à l'intérieur de la partie mobile 58.

La première partie 71 et la deuxième partie 72 ont une forme complémentaire, de manière à ce que la première partie et la deuxième partie puissent être reliées. En particulier, la première partie 71 et la deuxième partie 72 sont reliées de manière amovible. Par exemple, la première partie 71 est une partie femelle et la deuxième partie 72 est une partie mâle. Ainsi, la deuxième partie 72, mâle, est configurée pour être insérée dans la première partie 71, femelle.

Lorsque la deuxième partie 72 est insérée dans la première partie 71 du bornier modulaire 70, la partie mobile 58 entre en contact avec le corps 62 de la partie mobile 56.

De préférence, le bornier modulaire 70 est fait en matériau polymère.

La première partie 71 et la deuxième partie 72 sont traversées par un ensemble de broches de contact configurées pour recevoir l'ensemble de câbles traversant la prise 50. Ainsi, lorsque la première partie 71 et la deuxième partie 72 sont reliées, un contact électrique est établi entre la partie fixe 56 et la partie mobile 58.

Le support 82 comprend une surface postérieure 84, deux surfaces latérales 85 et une surface antérieure 86. La surface postérieure 84, visible notamment sur la figure 4, est sensiblement parallèle à la face 78 de la partie mobile 58. Les surfaces latérales 85 sont sensiblement parallèles entre elles.

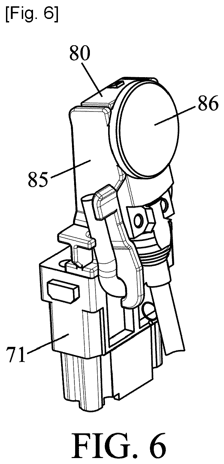

La surface antérieure 86, visible sur la figure 6, a avantageusement une forme et une dimension sensiblement égales à une forme et une dimension du deuxième trou de la face 78. En l'espèce, la surface antérieure 86 est sensiblement circulaire.

Le support 82 est installé dans la partie mobile 58 du boîtier 52. Ainsi, la surface antérieure 86 est destinée à s'insérer dans le deuxième trou de la face 78.

Le support 82 est en outre destiné à être relié sur le bornier modulaire 70. En particulier, le support 82 est destiné à être relié sur la deuxième partie 72 du bornier modulaire 70. Par exemple, le support 82 est vissée sur la deuxième partie 72 du bornier modulaire 70. Alternativement, le support 82 peut être réalisé d'un seul tenant avec la deuxième partie 72 du bornier modulaire.

Le support 82 est fait en matériau isolant. Alternativement, au moins la surface antérieure 86 du support 82 est faite en matériau isolant. Par exemple, le matériau isolant est un matériau polymère.

Le capteur 80 est installé dans la partie mobile 58. En particulier, le capteur 80 est installé en regard du deuxième trou de la face 78.

Plus précisément, le capteur 80 est installé dans le support 82 dans un espace formé entre les surfaces antérieure 86, postérieure 84 et latérales 85 du support 82. De préférence, le capteur 80 est vissé sur la surface postérieure 84.

Le capteur 80 est connecté en série à l'intérieur de la prise 50. En particulier, le capteur 80 est connecté en série avec les broches de contact du bornier modulaire 70.

Avantageusement, le capteur 80 est un capteur de position sans contact. De préférence, le capteur 80 est un capteur inductif. Alternativement, le capteur peut être un capteur électromécanique à contact, un capteur capacitif, un capteur magnétique, un capteur à ultrasons, un capteur optique, un capteur optoélectronique, un capteur laser, un capteur à lames souples, etc.

Le boîtier 52 comprend en outre au moins un élément d'ancrage 90. Dans l'exemple de réalisation illustré aux figures 3 et 5, l'au moins un élément d'ancrage 90 est disposé sur la partie fixe 56. En particulier, un premier élément d'ancrage 90 est positionné sur la face avant 63 du corps 62. Avantageusement, un deuxième élément d'ancrage (non visible) est positionné sur la face arrière 65 du corps 62. Chaque élément d'ancrage 90 fait saillie depuis la face avant 63 ou depuis la face arrière 65 selon une direction sensiblement perpendiculaire auxdites faces avant 63 et arrière 65.

Le moyen de verrouillage 54 comprend au moins un crochet 55 et un levier 57. Le moyen de verrouillage 54 comprend en outre au moins une surface de liaison 53. En particulier, le moyen de verrouillage 54 comprend le même nombre de surfaces de liaison 53 que de crochets 55. Dans l'exemple de réalisation des figures 3 à 5, le moyen de verrouillage comprend deux crochets 55, comme clairement montré sur la figure 5.

Chaque surface de liaison 53 relie le crochet 55 associé et le levier 57. De préférence, la surface de liaison 53 et le crochet 55 sont dans un même plan.

Chaque crochet 55 est conformé pour engager l'élément d'ancrage 90 respectif. Comme clairement montré sur la figure 5, le crochet 55 définit un espace d'insertion 59 de l'élément d'ancrage 90 et un espace de maintien 61 de l'élément d'ancrage 90.

L'espace d'insertion 59 a une largeur permettant un passage de l'élément d'ancrage 90 sans frottement ou avec un frottement réduit entre le crochet 55 et l'élément d'ancrage 90. L'espace de maintien 61 est configuré pour maintenir le crochet 55 engagé avec l'élément d'ancrage 90. En particulier, un pic de rétention 69 est prévu entre l'espace d'insertion 59 et l'espace de maintien 61.

Le pic de rétention 69 rétrécit la largeur de l'espace d'insertion 59 de manière à provoquer un frottement entre le crochet 55 et l'élément d'ancrage 90. Ainsi, afin de passer de l'espace d'insertion 59 à l'espace de maintien 61, ou de l'espace de maintien 61 à l'espace d'insertion 59, un effort doit être appliqué sur le crochet 55. Ainsi, en l'absence d'un tel effort, le pic de rétention 69 assure le maintien de l'élément d'ancrage 90 dans l'espace de maintien 61.

Le levier 57 s'étend sensiblement perpendiculairement par rapport à la surface de liaison 53. En particulier, le levier 57 s'étend depuis une extrémité de la surface de liaison 53, l'extrémité étant distale par rapport au crochet 55.

De préférence, une surface du levier 57 est supérieure à une surface du deuxième trou de la face 78 de la partie mobile 58.

Avantageusement, le moyen de verrouillage 54 est fait en matériau métallique. Alternativement, au moins le levier 57 est fait en matériau métallique.

Le moyen de verrouillage 54 est relié au boîtier 52 de la prise 50. En particulier, le moyen de verrouillage 54 est relié à la partie mobile 58 du boîtier 52. Plus précisément, le moyen de verrouillage 54 est relié à la face avant 73 et à la face arrière 75 de la partie mobile 58. Le moyen de verrouillage 54 est monté rotatif autour d'un axe A1 par rapport à la partie mobile 58. L'axe A1 est sensiblement perpendiculaire à la surface de liaison 53. Ainsi, lorsque la partie mobile 58 du boîtier 52 est connectée sur la partie fixe 56, le moyen de verrouillage 54 peut se déplacer entre une position déverrouillée et une position verrouillée.

La figure 5 montre la position déverrouillée. Dans la position déverrouillée, le moyen de verrouillage 54 est libéré par rapport à l'élément d'ancrage 90. Ainsi, la partie mobile 58 peut être séparée de la partie mobile 58 du boîtier 52.

La figure 3 montre la position verrouillée. Dans la position verrouillée, le moyen de verrouillage 54 engage l'élément d'ancrage 90. En particulier, l'élément d'ancrage est maintenu dans l'espace de maintien 61. Ainsi, la partie mobile 58 est maintenue en position par rapport à la partie fixe 56.

La prise 50 est configurée pour permettre le passage du disjoncteur 40 entre la position embrochée et la position débrochée.

En particulier, pour que le disjoncteur soit autorisé à se déplacer entre les positions embrochée et débrochée, la prise 50 doit être connectée au disjoncteur 40 et le mécanisme de verrouillage 54 doit être dans la position verrouillée.

Le capteur 80 permet de détecter la position verrouillée du mécanisme de verrouillage 54. En particulier, dans la position verrouillée, le levier 57 est placé devant le trou de la face 78 de la partie mobile 58. Avantageusement, le moyen de verrouillage 54 est conformé de manière à ce que dans la position verrouillée, le levier 57 repose directement sur la surface antérieure 86 du support 82.

Ainsi, dans la position verrouillée, le levier 57 fait face au capteur 80. Le capteur 80 peut donc détecter la présence du levier 57. La détection de la présence du levier 57 permet au capteur 80 d'identifier la position verrouillée du moyen de verrouillage 54.

Dans la position verrouillée, la surface antérieure 86 est interposée entre le capteur 80 et le moyen de verrouillage 54. Plus précisément, la surface antérieure 86 du support 82 est interposée entre le levier 57 et le capteur 80. Il est ainsi possible d'améliorer la précision de la détection de la position verrouillée, car il est possible de modifier l'épaisseur de la surface antérieure 86 interposée entre le capteur 80 et le moyen de verrouillage 54. Ceci permet de modifier le type de capteur ou sa sensibilité par exemple, sans avoir à modifier le reste de la prise, tout en maintenant ou en améliorant la précision de la détection. Aussi, une épaisseur de la surface 86 est dimensionnée de manière à ce que le seuil de détection du capteur 80 ne soit atteint que lorsque le pic de rétention 69 du crochet 55 est bien franchi. La surface antérieure 86 étant faite en matériau polymère, des éventuelles interférences entre la partie mobile 58, métallique, et le capteur 80 inductif sont limitées. Ainsi, la détection du levier 57, et donc, la détection de la position verrouillée, est plus précise.

Avantageusement, lorsque la position verrouillée est détectée, le moteur de réarmement 48 est alimenté électriquement, permettant le rechargement du ressort de fermeture afin de provoquer la fermeture des contacts 41. Ainsi, dans la position verrouillée, le disjoncteur est réarmé. Avantageusement, lorsque le capteur 80 détecte la position verrouillée, le déplacement du chariot 42 est autorisé. Ainsi, lorsque la position verrouillée est détectée, le déplacement du disjoncteur 40 entre la position débrochée et la position embrochée est autorisé. Par ailleurs, afin de déplacer le disjoncteur 40 entre les positions embrochée et débrochée, la porte du compartiment appareillage 28 doit être fermée.

Dans la position déverrouillée, le levier 57 ne fait pas face au capteur 80. Le capteur 80 est donc incapable de détecter la présence du levier 57. Lorsque le capteur 80 ne détecte pas la présence du levier 57, la position déverrouillée du moyen de verrouillage 54 est identifiée par le capteur 80.

Lorsque le capteur 80 détecte la position déverrouillée, le déplacement du disjoncteur 40 de la position débrochée à embrochée à partir du déplacement du chariot 42 est inhibé.

Accessoirement, lorsque la position déverrouillée est détectée, le capteur 80 provoque le désarmement du disjoncteur 40 à partir d'un cycle O-F-O. Ainsi, le disjoncteur 40 est désarmé avant extraction du compartiment appareillage de manière à éviter tout risque lors de la manipulation de l'installation électrique 10 par l'opérateur.

Optionnellement, la commande de désarmement/réarmement du disjoncteur, et/ou la commande d'autorisation/interdiction de déplacement du chariot peut être directement envoyée par le capteur 80 aux éléments impliqués. Alternativement, le capteur peut communiquer à un système numérique de contrôle-commande (non illustré) la détection de la position verrouillée et/ou la détection de la position déverrouillée. Le système numérique de contrôle-commande sera donc configuré pour envoyer la commande de désarmement ou de réarmement au disjoncteur, ainsi que la commande d'autorisation ou d'interdiction de déplacement du chariot.

Comme précédemment expliqué, la prise 50 est installée entre le disjoncteur 40 et le compartiment basse tension 26. La prise 50 est une prise basse tension.

En fonction de la disposition de l'ensemble de câbles traversant la prise 50, le fonctionnement de la prise 50 peut être contrôlé par la cellule d'appareillage 20 ou par le disjoncteur 40. Par exemple, en fonction de la disposition de l'ensemble de câbles dans la prise 50, l'information relative à la position verrouillée ou déverrouillée détectée par le capteur 80 est reçue dans le disjoncteur 40 ou dans la cellule d'appareillage 20.

On note que le dispositif électrique 30 selon la présente invention permet d'incrémenter la sécurité lors des opérations de manipulation du disjoncteur 40 et de la prise 50.

Enfin, on note que les avantages exposés ci-dessus sont obtenus sans besoin de modifier une forme externe de la prise utilisée actuellement. Les prises actuellement utilisées peuvent donc être facilement adaptées à cette solution.

La présente divulgation ne se limite pas à l'exemple décrit ci-avant en regard des figures. La présente divulgation englobe également toutes les variantes et combinaisons que pourra envisager l'homme de l'art dans le cadre de la protection recherchée, qui est défini par les revendications.

Par exemple, selon un exemple de réalisation non illustré, l'élément d'ancrage pourrait être positionné sur la partie mobile 58 du boîtier 52. Dans cette alternative, le moyen de verrouillage 54 est monté rotatif sur la partie fixe 56.

## Revendications

1. Dispositif électrique (30) comprenant :
- un disjoncteur (40) destiné à être installé dans une cellule d'appareillage électrique (20), le disjoncteur (40) étant configuré pour être déplacé entre une position embrochée et une position débrochée, dans lequel le disjoncteur (40) est configuré pour être déplacé entre un intérieur et un extérieur de la cellule d'appareillage électrique (20) ;
- une prise (50) configurée pour être connectée au disjoncteur (40), la prise (50) comprenant un boîtier (52) et un moyen de verrouillage (54) relié audit boîtier (52), le moyen de verrouillage (54) étant configuré pour, lorsque la prise (50) est connectée au disjoncteur (40), se déplacer entre une position verrouillée, dans laquelle le moyen de verrouillage (54) engage au moins un élément d'ancrage (90) prévu sur le boîtier (52), et une position déverrouillée, dans laquelle le moyen de verrouillage (54) est libéré par rapport à l'au moins un élément d'ancrage (90), **caractérisé en ce que** la prise (50) comprend en outre un capteur (80) configuré pour détecter la position verrouillée et/ou la position déverrouillée du moyen de verrouillage (54), le capteur (80) étant en outre configuré pour provoquer un désarmement du disjoncteur (40) avant le déplacement du disjoncteur (40) depuis l'intérieur vers l'extérieur de la cellule d'appareillage électrique (20) lorsque le moyen de verrouillage (54) est dans la position déverrouillée et/ou pour provoquer un réarmement du disjoncteur (40) et autoriser le déplacement dudit disjoncteur (40) entre la position embrochée et la position débrochée lorsque le moyen de verrouillage (54) est dans la position verrouillée, dans lequel le capteur (80) est monté sur un support (82), le support (82) ayant une surface (86) isolante interposée entre le capteur (80) et le moyen de verrouillage (54).

2. Dispositif électrique (30) selon la revendication 1, dans lequel le capteur (80) est en outre configuré pour communiquer à un système numérique de contrôle-commande la détection de la position verrouillée et/ou de la position déverrouillée du moyen de verrouillage (54), le système numérique de contrôle-commande étant configuré pour commander le désarmement du disjoncteur (40) et/ou le réarmement du disjoncteur (40).

3. Dispositif électrique (30) selon l'une quelconque des revendications précédentes, dans lequel le moyen de verrouillage (54) comprend un levier (57) faisant face au capteur (80) lorsque le moyen de verrouillage (54) est dans la position verrouillée.

4. Dispositif électrique (30) selon la revendication 3, dans lequel le capteur (80) est un capteur de position apte à détecter le levier (57) lorsque le moyen de verrouillage (54) est dans la position verrouillée.

5. Dispositif électrique (30) selon la revendication 4, dans lequel le capteur (80) est un capteur inductif.

6. Dispositif électrique (30) selon l'une quelconque des revendications précédentes, dans lequel le capteur (80) est connecté en série dans la prise (50).

7. Dispositif électrique (30) selon l'une quelconque des revendications précédentes, dans lequel le capteur (80) est prévu à l'intérieur du boîtier (52).

8. Dispositif électrique (30) selon l'une quelconque des revendications précédentes, la revendication 3 s'appliquant, dans lequel la surface (86) du support (82) est interposée entre le capteur (80) et le levier (57).

9. Installation électrique (10) comprenant une cellule d'appareillage électrique (20) et un dispositif électrique (30) selon l'une quelconque des revendications précédentes, dans laquelle la prise (50) est en outre configurée pour être connectée à un compartiment basse tension (26) de la cellule d'appareillage électrique (20), la prise (50) étant installée entre le disjoncteur (40) et le compartiment basse tension (26), le compartiment basse tension (26) logeant des composants électriques basse tension.

10. Installation électrique (10) selon la revendication 9, dans laquelle le boîtier (52) comporte une partie fixe (56) et une partie mobile (58), la partie fixe (56) étant destinée à être installée sur le disjoncteur (40) ou sur le compartiment basse tension (26), la partie mobile (58) étant connectée de manière amovible sur la partie fixe (56), la partie mobile (58) étant maintenue en position par rapport à la partie fixe (56) lorsque le moyen de verrouillage (54) est dans la position verrouillée.

11. Installation électrique (10) selon la revendication 10, dans laquelle l'au moins un élément d'ancrage (90) est prévu sur la partie fixe (56) du boîtier (52), le moyen de verrouillage (54) étant relié à la partie mobile (58).

12. Installation électrique (10) selon la revendication 10 ou la revendication 11, dans laquelle le capteur (80) est logé dans la partie mobile (58) du boîtier (52).

13. Installation électrique (10) selon l'une quelconque des revendications 9 à 12, dans laquelle la cellule d'appareillage électrique (20) est une cellule moyenne tension ou haute tension.

## Patentansprüche

1. Elektrische Vorrichtung (30), die Folgendes umfasst:
- einen Schutzschalter (40), der zur Installation in einer Schaltanlagenzelle (20) bestimmt ist, wobei der Schutzschalter (40) zum Verlagern zwischen einer eingesteckten und einer ausgesteckten Position konfiguriert ist, wobei der Schutzschalter (40) zum Verlagern zwischen einem Innenbereich und einem Außenbereich der Schaltanlagenzelle (20) konfiguriert ist;
- eine Steckdose (50), die zum Anschließen an den Schutzschalter (40) konfiguriert ist, wobei die Steckdose (50) ein Gehäuse (52) und ein Verriegelungselement (54) umfasst, das mit dem Gehäuse (52) verbunden ist, wobei das Verriegelungselement (54) zum Verlagern zwischen einer verriegelten Position, in der das Verriegelungselement (54) mindestens in ein an dem Gehäuse (52) vorgesehenes Verankerungselement (90) einrastet, und einer entriegelten Position, in der das Verriegelungselement (54) in Bezug auf das mindestens eine Verankerungselement (90) freigegeben ist, konfiguriert ist, wenn die Steckdose (50) an dem Schutzschalter (40) angeschlossen ist, **dadurch gekennzeichnet, dass** die Steckdose (50) ferner einen Sensor (80) umfasst, der zum Erkennen der verriegelten und/oder der entriegelten Position des Verriegelungselements (54) konfiguriert ist, wobei der Sensor (80) ferner dazu konfiguriert ist, ein Auslösen des Schutzschalters (40) zu bewirken, bevor der Schutzschalter (40) aus dem Innenbereich in den Außenbereich der Schaltanlagenzelle (20) verlagert wird, wenn das Verriegelungselement (54) in der entriegelten Position ist und/oder ein Reset des Schutzschalters (40) zu bewirken und die Verlagerung des Schutzschalters (40) zwischen der eingesteckten und der ausgesteckten Position zu gestatten, wenn sich das Verriegelungselement (54) in der verriegelten Position befindet, wobei der Sensor (80) auf einer Halterung (82) angebracht ist, wobei die Halterung (82) eine isolierende Oberfläche (86) aufweist, die zwischen dem Sensor (80) und dem Verriegelungselement (54) angeordnet ist.

2. Elektrische Vorrichtung (30) nach Anspruch 1, wobei der Sensor (80) ferner dazu konfiguriert ist, einem digitalen Steuerungs- und Sicherungssystem die Erkennung der verriegelten und/oder der entriegelten Position des Verriegelungselements (54) mitzuteilen, wobei das digitale Steuerungs- und Sicherungssystem dazu konfiguriert ist, das Auslösen des Schutzschalters (40) und/oder das Reset des Schutzschalters (40) zu steuern.

3. Elektrische Vorrichtung (30) nach einem der vorhergehenden Ansprüche, wobei das Verriegelungselement (54) einen dem Sensor (80) gegenüberliegenden Hebel (57) umfasst, wenn sich das Verriegelungselement (54) in der verriegelten Position befindet.

4. Elektrische Vorrichtung (30) nach Anspruch 3, wobei der Sensor (80) ein Positionssensor ist, der dazu ausgelegt ist, den Hebel (57) zu erkennen, wenn sich das Verriegelungselement (54) in der verriegelten Position befindet.

5. Elektrische Vorrichtung (30) nach Anspruch 4, wobei der Sensor (80) ein induktiver Sensor ist.

6. Elektrische Vorrichtung (30) nach einem der vorhergehenden Ansprüche, wobei der Sensor (80) in der Steckdose (50) in Reihe angeschlossen ist.

7. Elektrische Vorrichtung (30) nach einem der vorhergehenden Ansprüche, wobei der Sensor (80) im Inneren des Gehäuses (52) vorgesehen ist.

8. Elektrische Vorrichtung (30) nach einem der vorhergehenden Ansprüche, wobei Anspruch 3 gilt, wobei die Oberfläche (86) der Halterung (82) zwischen dem Sensor (80) und dem Hebel (57) angeordnet ist.

9. Elektrische Anlage (10), die eine Schaltanlagenzelle (20) und eine elektrische Vorrichtung (30) nach einem der vorhergehenden Ansprüche umfasst, wobei die Steckdose (50) ferner zum Anschließen an ein Niederspannungsfach (26) der Schaltanlagenzelle (20) konfiguriert ist, wobei die Steckdose (50) zwischen dem Schutzschalter (40) und dem Niederspannungsfach (26) installiert ist, wobei das Niederspannungsfach (26) elektrische Niederspannungskomponenten aufnimmt.

10. Elektrische Anlage (10) nach Anspruch 9, wobei das Gehäuse (52) einen feststehenden Teil (56) und einen beweglichen Teil (58) aufweist, wobei der feststehende Teil (56) dazu bestimmt ist, an dem Schutzschalter (40) oder an dem Niederspannungsfach (26) installiert zu werden, wobei der bewegliche Teil (58) lösbar an dem feststehenden Teil (56) angeschlossen ist, wobei der bewegliche Teil (58) in Bezug auf den feststehenden Teil (56) in Position gehalten wird, wenn sich das Verriegelungselement (54) in der verriegelten Position befindet.

11. Elektrische Anlage (10) nach Anspruch 10, wobei das mindestens eine Verankerungselement (90) an dem feststehenden Teil (56) des Gehäuses (52) vorgesehen ist, wobei das Verriegelungselement (54) mit dem beweglichen Teil (58) verbunden ist.

12. Elektrische Anlage (10) nach Anspruch 10 oder Anspruch 11, wobei der Sensor (80) im beweglichen Teil (58) des Gehäuses (52) aufgenommen ist.

13. Elektrische Anlage (10) nach einem der Ansprüche 9 bis 12, wobei die Schaltanlagenzelle (20) eine Mittelspannungs- oder Hochspannungszelle ist.

## Claims

1. An electrical device (30) comprising:
- a circuit breaker (40) intended to be installed in an electrical equipment cell (20), the circuit breaker (40) being configured so as to be moved between an engaged position and a disengaged position, wherein the circuit breaker (40) is configured so as to be moved between an interior and an exterior of the electrical equipment cell (20);
- a plug (50) configured to be connected to the circuit breaker (40), the plug (50) comprising a housing (52) and a locking means (54) connected to said housing (52), the locking means (54) being configured so as, when the plug (50) is connected to the circuit breaker (40), to move between a locked position, in which the locking means (54) engages with at least one anchoring element (90) provided on the housing (52), and an unlocked position, in which the locking means (54) is released with respect to the at least one anchoring means (90), **characterized in that** the plug (50) further comprises a sensor (80) configured to detect the locked position and/or the unlocked position of the locking means (54), the sensor (80) being further configured so as to cause disarmament of the circuit breaker (40) before the circuit breaker (40) is moved from the interior to the exterior of the electrical equipment cell (20) when the locking means (54) is in the unlocked position and/or to cause rearmament of the circuit breaker (40) and allow the movement of said circuit breaker (40) between the engaged position and the disengaged position when the locking means (54) is in the locked position, wherein the sensor (80) is mounted on a support (82), the support (82) having an insulating surface (86) interposed between the sensor (80) and the locking means (54).

2. The electrical device (30) according to Claim 1, wherein the sensor (80) is further configured to communicate, to a digital monitoring/control system, detection of the locked position and/or of the unlocked position of the locking means (54), the digital monitoring/control system being configured to control the disarmament of the circuit breaker (40) and/or the rearmament of the circuit breaker (40).

3. The electrical device (30) according to any one of the preceding claims, wherein the locking means (54) comprises a lever (57) facing the sensor (80) when the locking means (54) is in the locked position.

4. The electrical device (30) according to Claim 3, wherein the sensor (80) is a position sensor able to detect the lever (57) when the locking means (54) is in the locked position.

5. The electrical device (30) according to Claim 4, wherein the sensor (80) is an inductive sensor.

6. The electrical device (30) according to any one of the preceding claims, wherein the sensor (80) is connected in series in the plug (50).

7. The electrical device (30) according to any one of the preceding claims, wherein the sensor (80) is provided inside the housing (52).

8. The electrical device (30) according to any one of the preceding claims, Claim 3 applying, wherein the surface (86) of the support (82) is interposed between the sensor (80) and the lever (57).

9. An electrical installation (10) comprising an electrical equipment cell (20) and an electrical device (30) according to any one of the preceding claims, wherein the plug (50) is further configured to be connected to a low-voltage compartment (26) of the electrical equipment cell (20), the plug (50) being installed between the circuit breaker (40) and the low-voltage compartment (26), the low-voltage compartment (26) accommodating low-voltage electrical components.

10. The electrical installation (10) according to Claim 9, wherein the housing (52) comprises a fixed portion (56) and a mobile portion (58), the fixed portion (56) being intended to be installed on the circuit breaker (40) or on the low-voltage compartment (26), the mobile portion (58) being removably connected to the fixed portion (56), the mobile portion (58) being held in position with respect to the fixed portion (56) when the locking means (54) is in the locked position.

11. The electrical installation (10) according to Claim 10, wherein the at least one anchoring element (90) is provided on the fixed portion (56) of the housing (52), the locking means (54) being connected to the mobile portion (58).

12. The electrical installation (10) according to Claim 10 or Claim 11, wherein the sensor (80) is housed in the mobile portion (58) of the housing (52).

13. The electrical installation (10) according to any one of Claims 9 to 12, wherein the electrical equipment cell (20) is a medium-voltage or high-voltage cell.
